# EUROPEAN PATENT APPLICATION

(11) **EP 0 837 557 A1**
(43) Date of publication of application: **22.04.1998**
(21) Application number: 96116494.4
(22) Date of filing: 15.10.1996
(51) Int. Cl.: H03F 1/56, H03F 3/195

(54) **High frequency intensity amplifier circuitry arrangement for indoor cable television**

(71) Applicant: Yee, Bark-Lee, Allentown, Pennsylvania 18103 (US)
(72) Inventor: Yee, Bark-Lee, Allentown, Pennsylvania 18103 (US)
(74) Representative: Grünecker, Kinkeldey, Stockmair & Schwanhäusser Anwaltssozietät

(57) **Abstract**

A high frequency amplifier circuitry arrangement for indoor cable television includes an amplifier that has high frequency and high power; an impedance matching circuitry for providing adequate impedance matching; a direct current bias voltage circuitry for providing the amplifier with direct current bias; a direct current choking capacitor unit for blocking out the direct current signal, so that the frequency of a program signal input from a cable television program signal port is between 5 MHz to 1000 MHz (1 GHz), and has a power gain of 10 db, 20 db or 25 db.

## Description

### Background of the Present Invention

Due to the fact that the frequency intensity of the wireless television is limited by nature, it is impossible to increase the number of channel infinitely. However, according to the various needs of people and the improvement of human technology, cable television can properly fulfill the public needs of different communities because it doesn't utilize the frequency intensity of wireless television. Therefore, the growing rate of the cable television in different communities is at high gear. Furthermore, the program providers of every channel have diverse taste and all the cable television merchants would provide various types of program according to different taste of each community. The percentage of family installing cable television has increase annually, so that the number of audience of the cable television program has very high increasing potential in future.

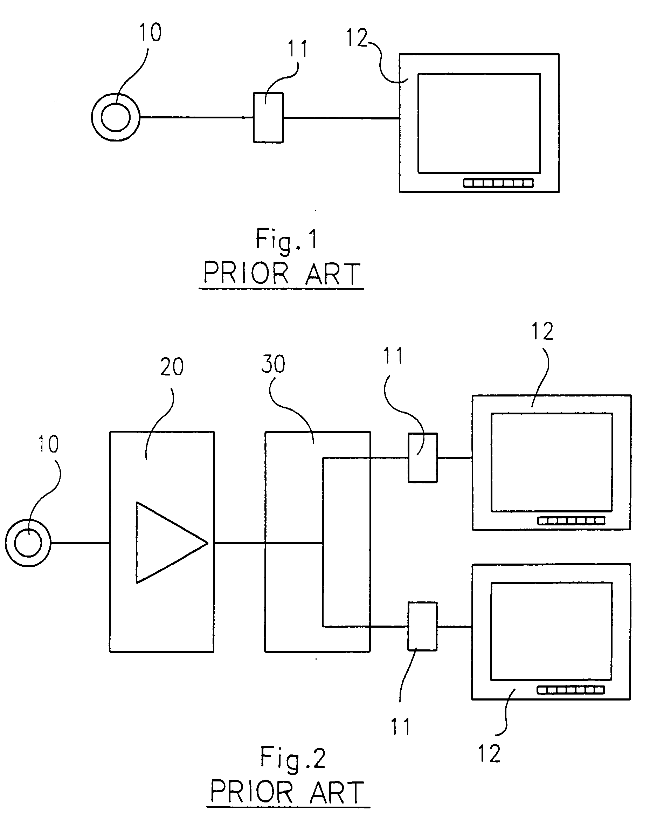

Referring to Fig. 1, a conventional indoor visual installation for cable television is illustrated. It comprises a program signal port 10, a channel selector 11, and a television 12, in which the cable television production companies utilize cable or fiber to connect directly to the home or building antenna of the subscriber, so as to deliver the program signal to the indoor program signal port 10. Then the subscriber connects the cable television signal from the program signal port 10 to the cable television channel selector 11 through a cable. The channel selector 11 is then connected to the AV terminal of the television 12. At this moment, the subscriber of the cable television can select different channels for desired television program by controlling the channel selector 11.

Under normal condition, the cable television merchant only provides to each subscriber one program signal port 10 (this is the monthly cost unit for the subscriber) which means that each subscriber can only view the cable television program through one television. However, in society today, many families have two or more television sets. In order to simultaneously provide cable television program from the program signal port 10 to both or more sets of television and the subscriber doesn't need to pay any extra fee, as shown in Fig. 2, the current method of solving this problem is to install a low frequency intensity amplifier 20 and a video signal divider 30 between the output end of the program signal port 10 and the input end of the channel selectors 11 of all the television sets. In Fig. 2, a two-way divider is used as an example. If there are three or more televisions, the subscriber can install a three-way or four-way divider. The low frequency intensity amplifier 20 is adapted to amplify and intensify the program signal output from the program signal port 10. In addition, the amplified and intensified program signal is then deliver to each television 12 for viewing through the video signal divider 30.

However, in the market today, the cable television merchant can only provide a frequency intensity between 5 to 552 MHz to deliver program signal. Each channel used about 6 MHz, so that this frequency intensity can provide for up to 92 channels. Such conventional condition can only fulfill the present one-way program. In accordance with the increasing number of different channels and more diverse programs and the improvement from simply one-way program to two-way program broadcasting, the merchant is slowly replacing the current cable wires by the fiber wires in order to improve the quality of the cable television business. Furthermore, the utilizing of fiber wires can also enable the cable television merchant to maintain the competitive advantage and, in the future, to access the internet through the cable television, or further develop in the future E-mail business. Therefore, in the near future, the frequency intensity of the cable television will be increased to 1 GHz. Thereby the conventional indoor low frequency intensity amplifier 20 can not fulfill the requirement of such 1 GHz high frequency intensity. Hence, the need of an indoor high frequency intensity amplifier for the subscriber is even more obvious and important.

As described above, if the program signal of the high frequency intensity cable television needs to provide for two or more televisions, the cable television high frequency intensity amplifier is required to have the following electrical characters:

Firstly, one must consider the factor of power gain. The cable television high frequency intensity amplifier needs to have adequate and stable power gain. After the program signal port 10 provided by the cable television merchant is amplified with adequate power gain, two or more televisions of the subscriber broadcast programs through the fiber cable transmission. Due to the location of the indoor television and the signal of the program signal port has different intensity, therefore, a cable television high frequency intensity amplifier which has different power gains is highly desired to meet various conditions. Whereby, the inventive goal of the present invention is focused on how to achieve a power gain range of 10db, 20db and 25 db.

Secondly, isolation input to output is another essential factor to be considered. It means that the indoor cable television high frequency intensity amplifier needs to have an excellent isolation input to output. In other words, the program signal of any one television of the subscriber would not affect the program signal of another television or other televisions. If the isolation input to output is not in good condition, it would cause two or more television sets of the subscriber mutually disturbed during the cable television program broadcasting. Whereby, the quality of the program signal received is greatly decreased which will lower the satisfaction of program viewing. Accordingly, the isolation input to output is a very important design factor for the cable television high frequency intensity amplifier. General speaking, when the isolation input to output value is greater than -25 db, the receiving signals of the televisions would not be mutually disturbed, so that an excellent TV viewing quality can be achieved.

Furthermore, there is still another very important factor that will affect the quality of TV viewing, i.e. the return loss. If the indoor cable television high frequency intensity amplifier has an excellent return loss, the television of the subscribe would not have any input or output reflection signal. It means that no ghost image will appear on the TV screen. Therefore, the return loss is the reflection of any broadcasting signal from the signal input or output port which will be received by the indoor cable television high frequency intensity amplifier. Hence, when these reflecting broadcasting signals return back to the television connected with the signal output port, the ghost image would not appear on the TV screen. Normally, when the return loss value is less than -12 db, the ghost image would not appear, so that an excellent TV viewing quality can be achieved.

### Summary of the Present Invention

The main objective of the present invention is to provide a high frequency intensity amplifier circuitry arrangement for indoor cable television, capable of delivering cable television program signal from a cable television program signal port to two or more than two television sets under a power gain of 10db, 20db or 25db for achieving an excellent TV viewing quality.

Another objective of the present invention is to provide a high frequency intensity amplifier circuitry arrangement for indoor cable television (10db), which comprises a high frequency and high power gain amplifier, an impedance matching circuitry for providing adequate impedance matching, a direct current bias voltage circuitry for providing the amplifier with direct current bias voltage, a direct current choking capacitor unit for choking any direct current signal. Thereby, a program signal input to the program signal port with frequency range between 5 MHz to 1 Ghz has a power gain of 10 ± 1 db, 20 ± 1 db, or 25 ± 1 db.

Another objective of the present invention is to provide a high frequency intensity amplifier circuitry arrangement for indoor cable television, which has a isolation input to output greater than -25 db when the program signal has a frequency range of 5 MHz to 1 GHz.

Another objective of the present invention is to provide a high frequency intensity amplifier circuitry arrangement for indoor cable television, which has a return loss less than -12 db when the program signal has a frequency range between 5 MHz to 1 Ghz.

Accordingly, the present invention provides a high frequency amplifier circuitry arrangement for indoor cable television comprising a first amplifier circuitry. The first amplifier circuitry comprises an amplifier that has high frequency and high power; an impedance matching circuitry for providing adequate impedance matching; a direct current bias voltage circuitry for providing the amplifier with direct current bias; a direct current choking capacitor unit for blocking out the direct current signal so that the frequency of a program signal input from a cable television program signal port is between 5 MHz to 1000 MHz (1 GHz), and has a power gain of 10 db, 20 db or 25 db.

The present invention further comprises a second amplifier circuitry connecting with the first amplifier circuitry. The second amplifier circuitry comprises a second high frequency and power gain amplifier, a second impedance matching circuitry connecting with the second amplifier for providing impedance matching, a third direct current choking capacitor connected between the amplifier and the video signal divider, and a second direct current bias voltage circuitry connected between the second impedance matching circuitry and the first direct current bias voltage of the first amplifier circuitry for providing a direct current bias voltage for the second amplifier.

The characteristic and other objectives of the present invention would be disclosed in the following with the preferred embodiment and corresponding drawings so as to explain the present technology to those who are skilled in art.

### Brief Description of the Drawings

Fig. 1 is a schematic view of a conventional indoor video installation of the cable television.
Fig. 2 is a schematic view of a conventional indoor video installation simultaneously for two television sets.
Fig. 3 is an electrical circuitry diagram of a first preferred embodiment of the present invention.
Fig. 4 is a frequency chart of the power gain of the first embodiment.
Fig. 5 is a frequency chart of the isolation input to output of the first embodiment.
Fig. 6 is a frequency chart of the output return loss of the first embodiment
Fig. 7 is a frequency chart of the input return loss of the first embodiment.
Fig. 8 is an electrical circuitry diagram of a second preferred embodiment of the present invention.
Fig. 9 is an electrical circuitry diagram of a third preferred embodiment of the present invention.

### Detailed Description of the Preferred Embodiment

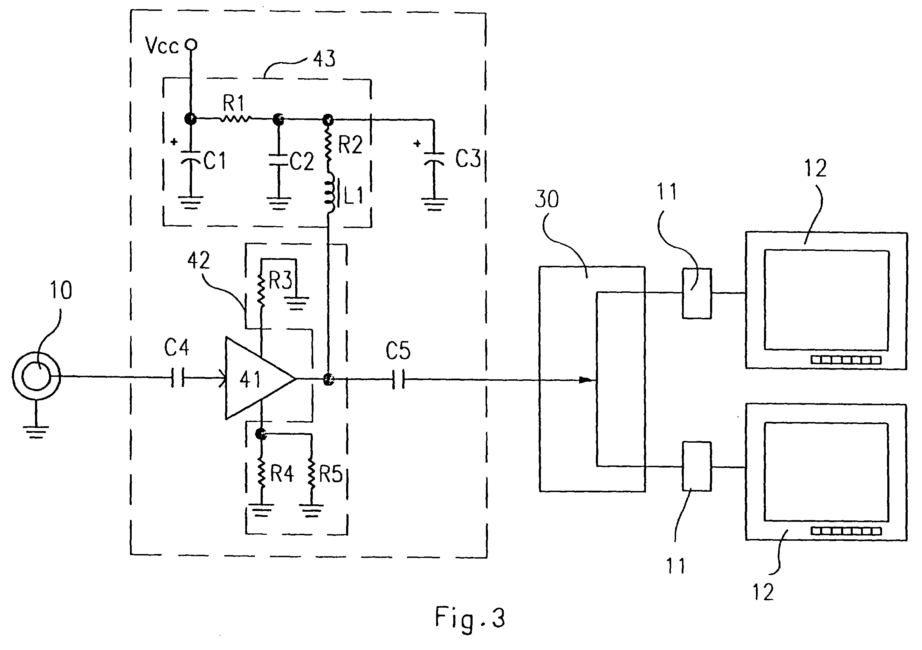

Referring to Fig. 3 of the drawings, a high frequency intensity amplifier circuitry arrangement for indoor cable television according to a first preferred embodiment of the present invention is illustrated. The high frequency intensity amplifier circuitry arrangement comprises an amplifier 41, an impedance matching circuitry 42, a direct current bias voltage circuitry 43, and a direct current choking capacitor unit having two direct current choking capacitors C4 and C5. The high frequency intensity amplifier circuitry arrangement for indoor cable television of the present invention is connected between a program signal port 10 and a video signal divider 30 which is further connected with two or more than two televisions 12 through a plurality of channel selectors 11 in the usual manner.

The amplifier 41 is a high frequency and high power gain amplifier, such as a MAR 7SM type amplifier according to the first embodiment. An input end of the amplifier 41 is connected to the program signal port 10 and an output end of the amplifier 41 is connected to the video signal divider 30. Certainly, other equivalent amplifiers having equal function can be used as the amplifier 41.

The impedance matching circuitry 42 which provides adequate impedance matching comprises two resistors R3, R4 connected with the amplifier 41, wherein a third resistor R5 is connected between the resistor R4 and the amplifier 41. The three resistors R3, R4 and R5 are grounded. The schedule impedance value on an AV terminal of each television 12 is 75 ohm while the output impedance of the amplifier 41 is normally at 50 ohm. Therefore, by utilizing the impedance matching circuitry 42 to convert the output impedance of the amplifier 41 to the schedule impedance value of the AV terminal of each television 12, the television 12 can achieve the maximum power.

The direct current choking capacitor C4 is connected between the program signal port 10 and the input end of the amplifier 41 and the direct current choking capacitor C5 is connected between the output end of the amplifier 41 and the video signal divider 30. The main objective of the two direct current choking capacitors C4, C5 are to stop any signal with direct current ingredient. The capacitors C4 connected to the input end of the amplifier 41 prevents any mix and disorderly direct current (D.C.) signal from inputting to the amplifier 41, so that only the alternating current (A.C.) program signal is allowed to enter the amplifier 41. The capacitor C5 connected to the output end of the amplifier 41 has the same function.

The direct current bias voltage circuitry 43, which provides a direct current bias voltage for the amplifier 41. comprises two resistors R1, R2, three grounded capacitors C1, C2, C3, and an inductance L1. A direct current voltage source Vcc is connected with the capacitor C1. The resistor R1 is connected between the two capacitors C1 and C2. The resistor R2 is connected to the capacitors C2 and C3. The inductance L1 is connected between the resistor R2 and the output end of the amplifier 41. The main objective of the direct current bias voltage circuitry 43 is that when the bias amplifier 41 is at a predetermined direct current voltage, enabling the alternating current signal of the video signal can use such predetermined direct current voltage as a standard oscillation (This is the basic design principle of the amplifier signal input circuitry.), the direct current voltage source Vcc will be bypassed through the capacitors C1, C2, C3. The capacitors C1 and C3 have a function of filtering low frequency wave. The capacitor C2 has a function of filtering high frequency wave. The resistors R1, R2 are for lowering the voltage. The inductance L1 is a RF choke, capable of self-inducing to form a choking function for eliminating the RF mix and disorderly signal with extreme high frequency. Therefore the direct current bias voltage circuitry 43 utilizes the resistors R1, R2 to lower the voltage, the capacitors C1, C2, C3 to eliminate the low and high frequency mix and disorderly signal, and further utilizes the inductance L1 to form choke to eliminate the extreme high frequency RF mix and disorderly signal, so as to provide the amplifier 41 with the necessary direct current bias.

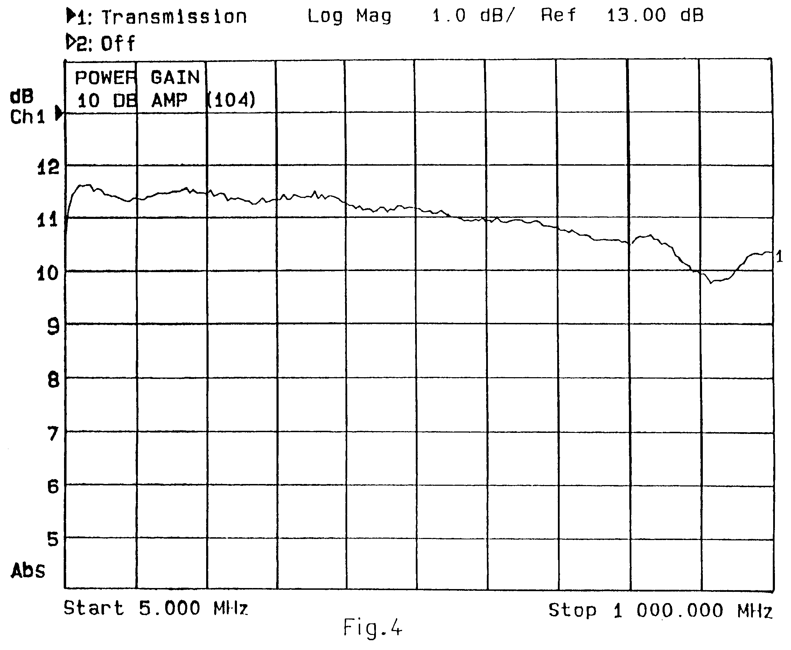

Referring to Fig. 4 to Fig. 7, the frequency charts of the different lab results of the first embodiment of the present invention can prove and fulfill the above performance requirement.

Firstly, according to Fig. 4, the frequency chart of power gain of the present invention, said frequency chart has a Y-axis of db value and a X-axis of frequency value, in which the x-axis is in log unit within a range from 5 MHz to 1 GHz. The preset goal of the power gain of the present embodiment is 10db. As shown in Fig. 4, the power gain from 5 MHz to 1 GHz maintains at 10 ± 1db. However, when the conventional indoor amplifier is at high frequency, the power gain would drop in large amount. In accordance with the present invention, even when the frequency reach as high as 1 GHz, the power gain would not drop and still maintains above 10 db.

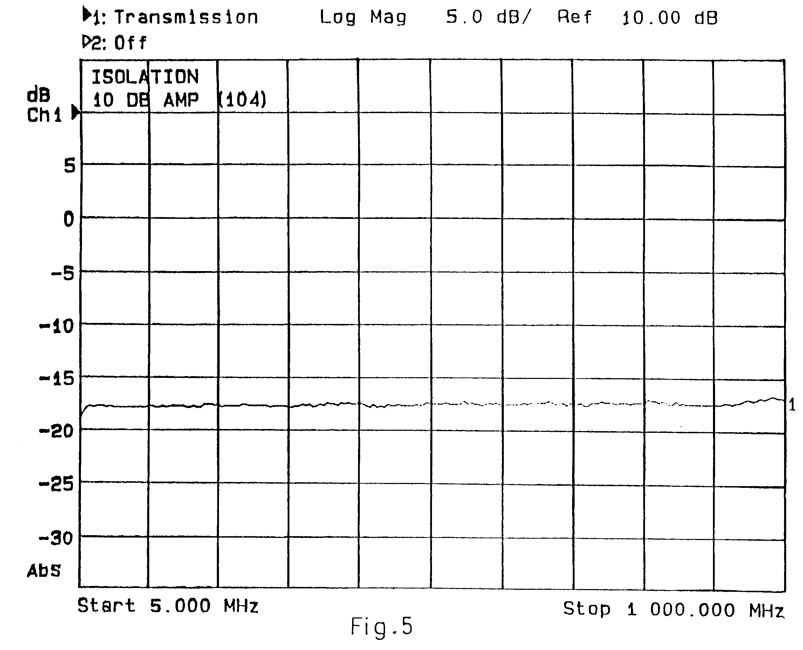

Secondly, according to Fig. 5, illustrating the frequency chart of the isolation input to output of the present invention, the frequency chart has a Y-axis of db value and a X-axis of frequency value, in which the x-axis is in log unit and a range from 5 MHz to 1 GHz. The preset goal of the isolation input to output of the present invention is greater than -25db. As shown in Fig. 5, the isolation input to output from 5 MHz to 1 GHz at -17 ± 1 db is far greater than the goal of -25 db, so that the present invention has a very excellent result in isolation input to output.

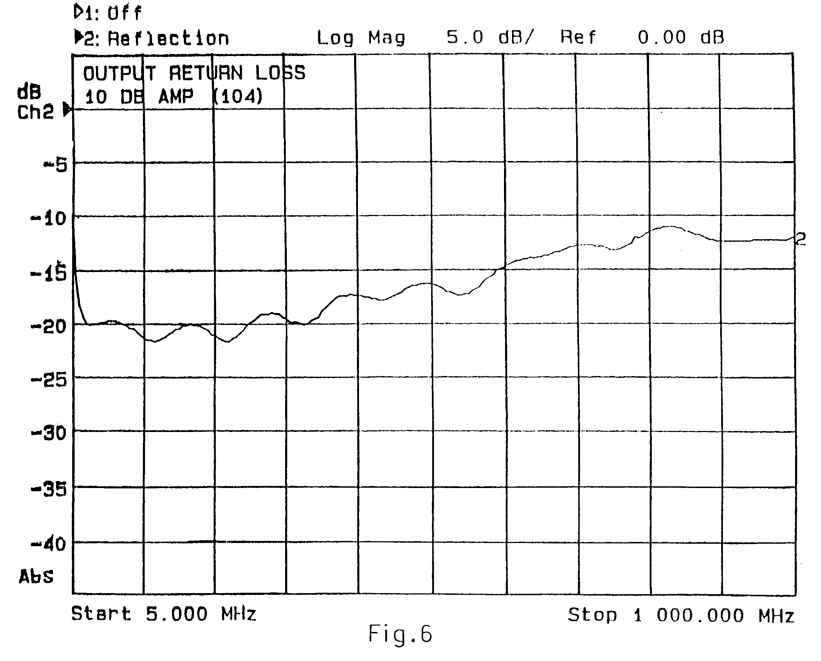

Thirdly, according to Fig. 6, illustrating the frequency chart of the output return loss of the present invention, the frequency chart has a db Y-axis and a frequency X-axis, in which the X-axis is in log unit and a range from 5 MHz to 1 GHz. The preset goal of the output return loss of the present invention is less than -12db. As shown in Fig. 6, all the return loss from 5 MHz to 1 GHz is less than -12db, so that the present invention has a very excellent result in output return loss.

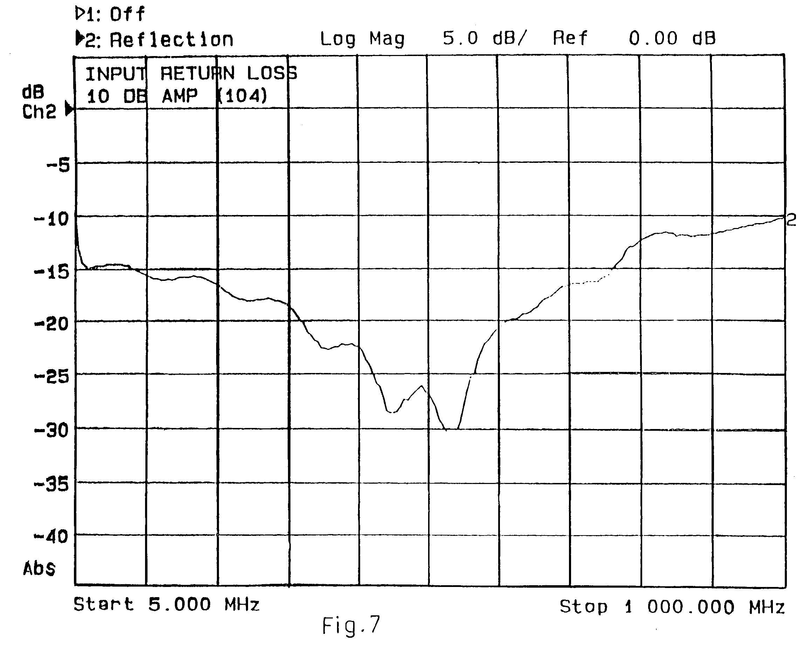

In addition, according to Fig. 7, illustrating the frequency chart of the input return loss of the present invention, the frequency chart has a db Y-axis and a frequency X-axis, in which the x-axis is in log unit and a range from 5 MHz to 1 GHz. The preset goal of the input return loss of the present invention is less than -12db. As shown in Fig. 7, all the return loss from 5 MHz to 1 GHz is less than -12 db, so that the present invention has a very excellent result in input return loss.

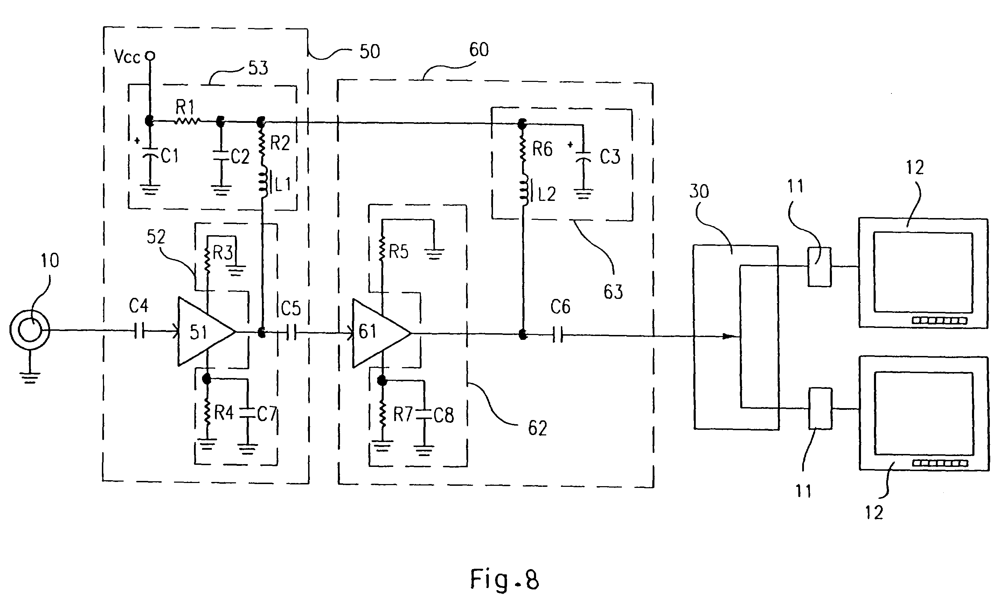

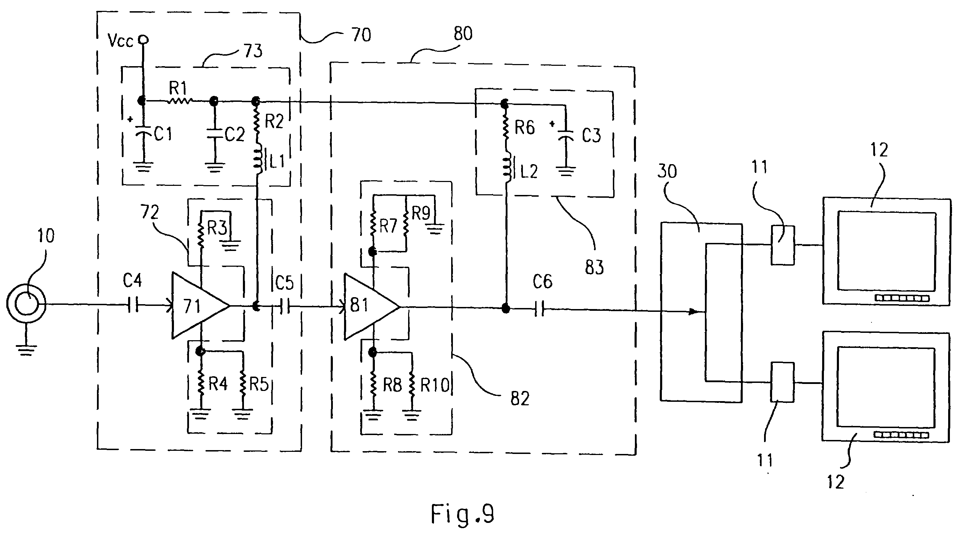

Referring to Fig. 8, a second preferred embodiment of the high frequency intensity amplifier circuitry arrangement for indoor cable television of the present invention is illustrated.
The high frequency intensity amplifier circuitry arrangement of the second embodiment comprises a first stage amplifier circuitry 50 which is connected with the program signal port 10 and a second stage amplifier circuitry 60 which is connected to the video signal divider 30. The program signal of the program signal port 10 first enters the first stage amplifier circuitry 50 to have a front stage amplify, and then enters the second stage amplifier circuitry 60 to have a rear stage amplify, so as to achieve a power gain of 20db under 1 GHz frequency intensity, an isolation input to output of greater than -25db, and an output and input return loss of less than -12db.

The first stage amplifier circuitry 50, similar to the above first embodiment, comprises an amplifier 51, an impedance matching circuitry 52, a direct current bias voltage circuitry 53, and a direct current choking capacitor unit having two direct current choking capacitors C4, C5. The amplifier 51 is a MAR-7SM type amplifier. The impedance matching circuitry 52 which provides adequate impedance matching comprises two resistors R3, R4 connected with the amplifier 51. A capacitor C7 is connected between the resistor R4 and the amplifier 51. The two resistors R3, R4 and the capacitor C7 are grounded.

Similar to the above first embodiment, the direct current choking capacitor C4 of the second embodiment is connected between the program signal port 10 and the input end of the amplifier 51 and the direct current choking capacitor C5 is connected to the output end of the amplifier 51.

The direct current bias voltage circuitry 53, which provides direct current bias voltage for the amplifier 51. comprises two resistors R1, R2, two grounded capacitors C1, C2, and an inductance L1. A direct current voltage source Vcc is connected with the capacitor C1. The resistor R1 is connected between the two capacitors C1 and C2. The resistor R2 is connected to the capacitor C2. The inductance L1 is connected between the resistor R2 and the output end of the amplifier 51.

The second stage amplifier circuitry 60 and the first stage amplifier circuitry 50 of the present second embodiment are almost the same. The second stage amplifier circuitry 60 comprises an amplifier 61 which has input end is connected with the capacitor C5, an impedance matching circuitry 62, a direct current bias voltage circuitry 63, and a direct current choking capacitor C6. The amplifier 61 is a MAR-3SM type amplifier. The impedance matching circuitry 62, which has a circuitry structure same as the impedance matching circuitry 52 of the first stage amplifier circuitry 50, comprises two grounded resistors R5, R7 connected with the amplifier 61 and a grounded capacitor C8 connected between the amplifier 61 and the resistor R7. The direct current bias voltage circuitry 63 comprises a resistor R6, a grounded capacitor C3 and an inductance L2, in which the resistor R6 is connected to the resistor R2 and the capacitor C3 in parallel manner. The inductance L2 is connected in series with the resistor R6 and the output end of the amplifier 61. The capacitor C6 is connected to an output end of the amplifier 61. The second stage amplifier circuitry 60 is connected with the video signal divider 30 via the capacitor C6.

According to the present second embodiment, the output impedance formed by the resistors R3, R4 and the capacitor C7 of the first stage amplifier circuitry 50 mutually matches the input impedance of the amplifier 61 of the second stage amplifier circuitry 60. The output impedance formed by the resistors R7, R8 and the capacitor C8 of the second stage amplifier circuitry 60 matches the schedule impedance of the AV terminal of each television 12.

Referring to Fig. 9, a third preferred embodiment of a high frequency intensity amplifier circuitry arrangement for indoor cable television of the present invention is illustrated. The high frequency intensity amplifier circuitry arrangement of the third embodiment comprises a first stage amplifier circuitry 70 which is connected with the program signal port 10 and a second stage amplifier circuitry 80 which is connected to the video signal divider 30. The program signal of the program signal port 10 first enters the first stage amplifier circuitry 70 to have a front stage amplify, and then enters the second stage amplifier circuitry 80 to have a rear stage amplify, so as to achieve a power gain of 25db under 1 GHz frequency intensity, an isolation input to output of greater than -25db, and an output and input return loss of less than -12db.

The first stage amplifier circuitry 70, similar to the above first embodiment, comprises an amplifier 71, an impedance matching circuitry 72, a direct current bias voltage circuitry 73, and a direct current choking capacitor unit having two direct current choking capacitors C4, C5. The amplifier 71 is a MAR-1SM type amplifier. The impedance matching circuitry 72, which provides adequate impedance matching, comprises three grounded resistors R3, R4 and R5. The resistors R3 and R4 are connected with the amplifier 71. The resistor R5 is connected between the resistor R4 and the amplifier 71.

Similar to the above first and second embodiments, the direct current choking capacitor C4 of the third embodiment is connected between the program signal port 10 and the input end of the amplifier 71 and the direct current choking capacitor C5 is connected to the output end of the amplifier 71.

The direct current bias voltage circuitry 73, which provides direct current bias voltage for the amplifier 71. comprises two resistors R1, R2, two grounded capacitors C1, C2, and an inductance L1. A direct current voltage source Vcc is connected with the capacitor C1. The resistor R1 is connected between the two capacitors C1 and C2. The resistor R2 is connected to the capacitor C2. The inductance L1 is connected between the resistor R2 and the output end of the amplifier 71.

The second stage amplifier circuitry 80 and the first stage amplifier circuitry 70 of the present third embodiment are almost the same. The second stage amplifier circuitry 80 comprises an amplifier 81 which has input end is connected with the capacitor C5, an impedance matching circuitry 82, a direct current bias voltage circuitry 83, and a direct current choking capacitor C6. The amplifier 81 is a MAR-7SM type amplifier. The impedance matching circuitry 82 comprises four grounded resistors R7, R8, R9, and R10. The resistors R7 and R8 are connected with the amplifier 81. The resistor R9 is connected in parallel with the resistor R7. The resistor R10 is connected between the amplifier 81 and the resistor R8. The direct current bias voltage circuitry 83 comprises a resistor R6, a grounded capacitor C3 and an inductance L2, in which the resistor R6 is connected to the resistor R2 and the capacitor C3 in parallel manner. The inductance L2 is connected in series with the resistor R6 and the output end of the amplifier 81. The capacitor C6 is connected to an output end of the amplifier 81. The second stage amplifier circuitry 80 is connected with the video signal divider 30 via the capacitor C6.

According to the third embodiment, the output impedance formed by the resistors R3, R4 and R5 of the impedance matching circuitry 72 of the first stage amplifier circuitry 70 mutually matches the input impedance of the amplifier 81 of the second stage amplifier circuitry 80. The output impedance formed by the resistors R7, R8, R9, and R10 of the second stage amplifier circuitry 80 mutually matches the schedule impedance of the AV terminal of each television 12.

In conclusion, the subscriber of the cable television can install the high frequency intensity amplifier circuitry arrangement of the present invention between the cable television program signal port 10 and the video signal divider 30. Therefore, a plurality of circuitry features, including a power gain of 10db, 20db or 25db under a frequency intensity up to 1 GHz, an isolation input to output greater than -25db, and an input and output return loss less than -12db, can thus be achieved.

## Claims

1. A high frequency intensity amplifier circuitry arrangement for indoor cable television, comprising a first amplifier circuitry which comprises
a high frequency and power gain amplifier having an output end and an input end for connecting with a program signal port;
an impedance matching circuitry connecting with said amplifier for providing impedance matching;
a direct current choking capacitor unit, having a first direct current choking capacitor, which is connected between said program signal port and said input end of said amplifier, and a second direct current choking capacitor connected to said output end of said amplifier, for preventing a mix and disorderly direct current signal from inputting to said amplifier, so that only an alternating current program signal is allowed to enter said amplifier; and
a direct current bias voltage circuitry connected between a direct current voltage source and said impedance matching circuitry for providing a direct current bias voltage for said amplifier.

2. A high frequency intensity amplifier circuitry arrangement for indoor cable television, as recited in claim 1, in which said impedance matching circuitry comprises a first resistor, a second resistor and a third resistor, said amplifier being connected between said first resistor and said second resistor, said third resistor being connected in parallel with said second resistor, said first, second and third resistors being grounded.

3. A high frequency intensity amplifier circuitry arrangement for indoor cable television, as recited in claim 2, in which said direct current bias voltage circuitry comprises a fourth resistor, a fifth resistor, a grounded first capacitor, a grounded second capacitor, and an inductance, wherein said direct current voltage source is connected with said first capacitor, said fourth resistor connecting between said first and second capacitors, said fifth resistor connecting to said second capacitor, said inductance connecting between said fifth resistor and said output end of said amplifier.

4. A high frequency intensity amplifier circuitry arrangement for indoor cable television, as recited in claim 3, further comprising a grounded third capacitor connected with said fifth resistor, thereby said direct current voltage source is bypassed through said first, second and third capacitors when said amplifier is at a predetermined direct current bias voltage, wherein said fourth and fifth resistors lower said direct current voltage source, said first and third capacitors eliminating a low frequency mix and disorderly signal, said second capacitor eliminating a high frequency mix and disorderly signal, said inductance forming a choke to eliminate an extreme high frequency RF mix and disorderly signal, so that said amplifier is prodded with a predetermined direct current bias.

5. A high frequency intensity amplifier circuitry arrangement for indoor cable television, as recited in claim 4, in which said input end of said amplifier is connected with a program signal port via said first direct current choking capacitor and said output end of said amplifier is connected to a video signal divider via said second direct current choking capacitor, said video signal divider further connecting to two or more than two channel electors and televisions, thereby a program signal delivered from said program signal port, under a frequency range from 5 MHz to 1 GHz, has a power gain of 10 ± 1 db,an isolation input to output greater than - 25 db, and return loss less than -12 db.

6. A high frequency intensity amplifier circuitry arrangement for indoor cable television, as recited in claim 5, in which said amplifier is a MAR-7SM type amplifier.

7. A high frequency intensity amplifier circuitry arrangement for indoor cable television, as recited in claim 1, further comprising a second amplifier circuitry connected between said first amplifier circuitry and a video signal divider which is connected with two or more than two channel electors and televisions, in which said second amplifier circuitry comprises a second high frequency and power gain amplifier having an input end and an output end, a second impedance matching circuitry connecting with said second amplifier for providing impedance matching, a third direct current choking capacitor connected between said output end of said amplifier and said video signal divider, and a second direct current bias voltage circuitry connected between said second impedance matching circuitry and said direct current bias voltage of said first amplifier circuitry for providing a direct current bias voltage for said second amplifier.

8. A high frequency intensity amplifier circuitry arrangement for indoor cable television, as recited in claim 7, in which said impedance matching circuitry of said first amplifier circuitry comprises a grounded first resistor and a grounded second resistor, said amplifier being connected between said first resistor and said second resistor, wherein a grounded first capacitor is connected in parallel with said second resistor.

9. A high frequency intensity amplifier circuitry arrangement for indoor cable television, as recited in claim 8, in which said direct current bias voltage circuitry of said first amplifier circuitry comprises a third resistor, a fourth resistor, a grounded second capacitor, a grounded third capacitor, and an inductance, wherein said direct current voltage source is connected with said second capacitor, said third resistor connecting between said second and third capacitors, said fourth resistor connecting to said third capacitor, said inductance connecting between said fourth resistor and said output end of said amplifier.

10. A high frequency intensity amplifier circuitry arrangement for indoor cable television, as recited in claim 9, in which said input end of said second amplifier of said second amplifier circuitry is connected with said second direct current choking capacitor, said second impedance matching circuitry comprising a grounded fifth resistor and a grounded sixth resistor, said second amplifier being connected between said fifth resistor and said sixth resistor, a grounded fourth capacitor connected in parallel with said sixth resistor, so that an output impedance formed by said first and second resistors and said first capacitor of said first amplifier circuitry mutually matches an input impedance of said second amplifier of said second amplifier circuitry, and that an output impedance formed by said fifth and sixth resistors and said third capacitor of said second amplifier circuitry matches a schedule impedance of each said television.

11. A high frequency intensity amplifier circuitry arrangement for indoor cable television, as recited in claim 10, in which said second direct current bias voltage circuitry comprises a seventh resistor, a grounded fifth capacitor and a second inductance, wherein said seventh resistor is connected to said fourth resistor and said fifth capacitor in parallel manner, said second inductance being connected in series with said seventh resistor and said output end of said second amplifier.

12. A high frequency intensity amplifier circuitry arrangement for indoor cable television, as recited in claim 11, in which said amplifier is a MAR-7SM type amplifier and said second amplifier is a MAR-3SM type amplifier.

13. A high frequency intensity amplifier circuitry arrangement for indoor cable television, as recited in claim 7, in which said impedance matching circuitry of said first amplifier circuitry comprises a grounded first resistor and a grounded second resistor, said amplifier being connected between said first resistor and said second resistor, wherein a grounded third resistor is connected in parallel with said second resistor.

14. A high frequency intensity amplifier circuitry arrangement for indoor cable television, as recited in claim 13, in which said direct current bias voltage circuitry of said first amplifier circuitry comprises a fourth resistor, a fifth resistor, a grounded first capacitor, a grounded second capacitor, and an inductance, wherein said direct current voltage source is connected with said first capacitor, said fourth resistor connecting between said first and second capacitors, said fifth resistor connecting to said second capacitor, said inductance connecting between said fifth resistor and said output end of said amplifier.

15. A high frequency intensity amplifier circuitry arrangement for indoor cable television, as recited in claim 14, in which said input end of said second amplifier of said second amplifier circuitry is connected with said second direct current choking capacitor, said second impedance matching circuitry comprising a grounded sixth resistor and a grounded seventh resistor, said second amplifier being connected between said sixth resistor and said seventh resistor, a grounded eighth resistor being connected in parallel with said sixth resistor, a grounded ninth resistor being connected in parallel with said seventh resistor, so that an output impedance formed by said first, second and third resistors of said first amplifier circuitry mutually matches an input impedance of said second amplifier of said second amplifier circuitry, and that an output impedance formed by said sixth, seventh,eighth, and ninth resistors of said second amplifier circuitry mutually matches a schedule impedance of each television.

16. A high frequency intensity amplifier circuitry arrangement for indoor cable television, as recited in claim 15, in which said second direct current bias voltage circuitry comprises a tenth resistor, a grounded third capacitor of and a second inductance, wherein said tenth resistor is connected to said fifth resistor and said third capacitor in parallel manner, said second inductance being connected in series with said tenth resistor and said output end of said second amplifier.

17. A high frequency intensity amplifier circuitry arrangement for indoor cable television, as recited in claim 16, in which said amplifier is a MAR-1SM type amplifier and said second amplifier is a MAR-7SM type amplifier.
